# EUROPÄISCHE PATENTSCHRIFT

(11) **EP 4 218 136 B1**
(45) Veröffentlichungstag und Bekanntmachung des Hinweises auf die Patenterteilung: **22.05.2024**
(21) Anmeldenummer: 22801790.1
(22) Anmeldetag: 13.10.2022
(51) Int. Cl.: H03K 17/97, H03K 17/972

(54) **ANORDNUNG EINES SCHALTGERÄTES MIT EINEM FUNKTIONSMODUL, FUNKTIONSMODUL UND VERFAHREN ZUM BETRIEB EINES SOLCHEN**
ARRANGEMENT OF A SWITCHING DEVICE WITH A FUNCTIONAL MODULE, FUNCTIONAL MODULE AND METHOD FOR OPERATING THE SAME
AGENCEMENT D'UN DISPOSITIF DE COMMUTATION AVEC UN MODULE FONCTIONNEL, MODULE FONCTIONNEL ET SON PROCÉDÉ DE FONCTIONNEMENT

(30) Priorität: 09.12.2021 DE 102021132395
(43) Veröffentlichungstag der Anmeldung: 02.08.2023
(73) Patentinhaber: Insta GmbH, 58509 Lüdenscheid (DE)
(72) Erfinder: BECKER-HENNECKE, Ralph, 58239 Schwerte (DE)
(74) Vertreter: Haverkamp Patentanwälte PartG mbB
(86) Internationale Anmeldenummer: PCT/EP2022/078568
(87) Internationale Veröffentlichungsnummer: WO 2023/104379

(56) Entgegenhaltungen:
- EP-A2- 1 524 750
- AT-B1- 512 033
- DE-U1-202019 105 275

## Beschreibung

Die Erfindung betrifft eine Anordnung nach dem Oberbegriff des Anspruchs 1, ein Funktionsmodul und ein diesbezügliches Verfahren.

Funktionsmodule für elektrische/elektronische Schaltgeräte der Gebäudeinstallationstechnik (etwa *www.jung-group.com*/*de-DE*/*Wippschalter-Universal-Aus-Wechsel-10-AX-250-V1506-U*) , wobei auf das in einem Installationshohlraum befindliche elektrische/elektronische Schaltgerät ein Oberteil aufsetzbar ist, sind in der Regel dafür vorgesehen, über ihre unabhängigen Kanäle Aktoren und/oder Sensoren anzusteuern und zwar sowohl über einen Schalter oder Taster als auch über ein externes Gerät, beispielsweise ein mobiles Endgerät, via Funksignal. Derartige Funktionsmodule werden oftmals als Tasterschnittstelle, Dimmaktor, Schaltaktor oder Jalousieaktor eingesetzt und verfügen beispielsweise über zwei bis vier unabhängige Kanäle. Insofern sind die Funktionsmodule zur Erweiterung der Funktion elektrischer/elektronischer Schaltgeräte, beispielsweise eines Tasters oder Schalters, vorgesehen. Insofern handelt es sich bei einem Funktionsmodul um ein von dem elektrischen/elektronischen Schaltgerät zu unterscheidendes Bauteil. Dabei geht das Funktionsmodul eine Symbiose mit dem elektrischen/elektronischen Schaltgerät ein, indem es dem elektrischen/elektronischen Schaltgerät zusätzliche Funktionen zuweist und optional auch eine Fernbetätigung des elektrischen/elektronischen Schaltgerätes ermöglicht, beispielsweise das Dimmen von Leuchten durch Betätigung des elektrischen/elektronischen Schaltgerätes oder über eine Betätigung einer Applikation auf einem mobilen Endgerät.

Ein dem Oberbegriff des Hauptanspruches entsprechendes Funktionsmodul ist somit aus dem Stand der Technik beispielsweise gemäß der Website *nexentro.de* bekannt. Ein solches Funktionsmodul ist für die Gebäudeinstallationstechnik ausgelegt und weist ein aus einem Sockelteil und einem Deckelteil bestehendes Gehäuse auf, in dessen Innenraum auf zumindest einer elektrischen Leiterplatte die zur Funktion notwendigen elektrischen/elektronischen Bauteile untergebracht sind. Die elektrische Leiterplatte steht mit mehreren Anschlusskabeln zur Bildung einer Schnittstelle in Verbindung, über welche der Anschluss eines elektrischen/elektronischen Schaltgerätes erfolgt. Über mehrere unabhängige Kanäle können Telegramme ausgesendet werden, wobei die Telegramme zur Ansteuerung verschiedener Aktoren, beispielsweise Leuchten, Jalousien oder Steckdosen, oder Sensoren, beispielsweise Tastsensoren, Verwendung finden. Durch die Installation der Funktionsmodule in Installationsdosen werden die herkömmlichen, elektromechanischen Schalter "smart" gemacht.

Um das Tastsignal eines elektromechanischen Schalters an einem vorbekannten Funktionsmodul auswerten zu können, müssen mindestens drei Leitungen angeschlossen werden (Außenleiter beziehungsweise Phase L und geschalteter Ausgang/Steuerleitung und eine Steuerleitung zum Anschluss des Schalters). Bei Zweifach- und Jalousieanwendungen kommt eine weitere Steuerleitung hinzu; bei Schalt- oder Dimm-Anwendungen eine oder zwei Steuerleitungen.

Da durch den begrenzten Platzbedarf eine Unterbringung eines Funktionsmoduls und des Kabelgutes in der Unterputzdose herausfordernd ist, stellt das Weglassen jeder Leitung eine erhebliche Optimierung dar, insbesondere weil der Platzbedarf in dem Installationshohlraum und der Installationsaufwand signifikant abgesenkt werden können. Zudem wird durch die reduzierte Anzahl von zu verwendenden elektrischen Leitungen der Aufbau verständlicher und kann so durch die installierende Person sicherer und nachvollziehbarer durchgeführt werden. Mithin ergeben sich weniger Fehlerquellen. Aus diesen Gründen ergeben sich Hinderungsgründe für die breite Masse der Anwender, die kein Fachinstallateur sind, ein vorstehen beschriebenes Funktionsmodul einzusetzen.

Zudem erfordert die optimale Steuerung beispielsweise von Jalousien, Steckdosen und dimmbaren Leuchtmitteln mittels eines solchen Funktionsmoduls jedenfalls Taster, also einen nicht permanent geschlossenen Schalter. Damit wird unter Umständen eine aufwendige Umrüstung der bestehenden Gebäudesysteminfrastruktur von Schalter in Taster erforderlich - auch dieses schreckt viele potentielle Anwender von der Implementierung solcher Funktionsmodule zum "smart machen" von Dimmern, Jalousien und dergleichen ab.

AT 512 033 B1, US 2017/0062168 A1, DE 10 2005 063 070 A1 und EP 1 014 001 A2 offenbaren die Möglichkeit der Übertragung von Betätigungssignalen über Magnetfelder für Schaltgeräte. Die hier offenbarten Schaltgeräte sind bereits werksseitig vollständig montiert und werden, sofern überhaupt möglich, nur insgesamt ausgetauscht. Dies birgt den Nachteil erhöhter Kosten beim Umbau.

Ausgehend von diesem diskutierten Stand der Technik liegt der Erfindung die Aufgabe zugrunde, ein Funktionsmodul bzw. eine Anordnung zum Einbau in einen Installationshohlraum für ein elektrisches/elektronisches Schaltgerät der Gebäudeinstallationstechnik zu schaffen, mit dem der Verdrahtungsaufwand und damit die Installationskosten während des Einbaus reduziert, der in der Installationsdose verfügbare Raum erhöht und gleichzeitig der Betrieb eines Aktors ohne Ansteuerung durch einen Taster - sondern als Schalter - möglich ist, so dass eine besonders einfache und kostengünstige Nachrüstbarkeit der Funktionsmodule erreicht wird. Aufgabe ist es ferner, ein Verfahren zum Betreiben der Anordnung anzugeben.

Gelöst wird diese Aufgabe durch eine eingangs genannte, gattungsgemäße Anordnung mit den Merkmalen des Anspruchs 1. Die verfahrensbezogene Aufgabe wird gelöst durch ein Verfahren nach Anspruch 13. Vorteilhafte Ausgestaltungen ergeben sich aus den abhängigen Ansprüchen und der Beschreibung.

Der Kerngedanke der Erfindung besteht darin, dass das erfindungsgemäße Funktionsmodul den bis dato erforderlichen kabelbasierten Anschluss an das elektrische/elektronische Schaltgerät, insbesondere ein als Schalter oder Taster ausgebildetes Schaltgerät, entbehrlich macht:
Dieses wird vorteilhafterweise erreicht, indem eine magnetische Detektion der Stellung des an dem Schaltgerät fest gelagerten Betätigungselementes des Schaltgerätes durch das erfindungsgemäße Funktionsmodul vorgenommen und entsprechend ausgewertet wird.

Das zum Einbau in einen Installationshohlraum, etwa eine Installationsdose, geeignete, erfindungsgemäße Funktionsmodul für ein Schaltgerät der Gebäudeinstallationstechnik ist mittels des Betätigungselementes des Oberteils des Schaltgerätes beeinflussbar, indem an dem Schaltgerätes mindestens ein Magnet angeordnet ist. Dieser Magnet ändert bei der Betätigung des Betätigungselementes seine Position. Diese Positionsänderung wird durch einen Sensor zur Erfassung des Magnetfeldes bei Betätigung des Betätigungselementes detektiert. Es versteht sich vor diesem Hintergrund, dass das Schaltgerät nicht zwingenderweise selbst eine elektrische/elektronische Schaltmimik aufweisen muss; es genügt das Bereitstellen eines durch einen Nutzer in verschiedene Positionen bringbaren Betätigungselements.

Bevorzugt ist vorgesehen, dass der Magnet an dem Betätigungselement angeordnet ist. Der Vorteil der Platzierung des Magnets dem Betätigungselement (anstelle etwa an der schaltgerätbasisteilseitigen Oberteilaufnahme) besteht darin, dass eine größere Wegstrecke bei der Betätigung zurückgelegt wird, so dass die durch die Auswerteeinheit zu erfassende Messgröße, hier: das Magnetfeld, größer ist.

Gleichzeitig ist vorgesehen, dass das Funktionsmodul eine Auswerteeinheit aufweist, die dazu ausgelegt ist, zu erkennen, um welche Schaltgeräteart es sich bei dem Schaltgerät, durch welches das Funktionsmodul über das Magnetfeld angesteuert wird, handelt. Es gibt verschiedene Schaltgerätearten die sich bezüglich ihrer nutzerseitigen Betätigungsbewegung unterscheiden. So springt etwa ein Schalter im Gegensatz zu einem Taster nicht selbsttätig in seine Ursprungsstellung zurück. Ein Drehknauf, der durch eine Drehung eine stufenlose Einstellung ermöglicht, stellt wiederum eine andere Schaltgeräteart dar. Diese Information, um welche Schaltgeräteart es sich handelt, fließt in die Art und Weise, wie der Aktor aufgrund einer bestimmten erkannten Veränderung des Magnetfeldes angesteuert wird, ein.

Das Funktionsmodul kann insbesondere als Nachrüstsatz vorgesehen sein. Das Schaltgerät ist dann üblicherweise ein elektrisches/elektronisches Schaltgerät. Die vorhandene, in dem Schaltgerät elektrische/elektronische Aktorik wird nicht mehr benötigt; die Funktionalität wird durch das Funktionsmodul ersetzt. Ein vollständiges Austauschen des elektrisches/elektronisches Schaltgerätes ist jedoch nicht notwendig.

Geschickt wird sich durch die Erfindung die vorhandenen Schnittstellen zunutze gemacht, und zwar einerseits die Schnittstelle zwischen dem in einem Installationsraum fest installierten Schaltgerätbasisteil und einem Oberteil, was einen unkomplizierten Austausch des Betätigungselementes durch etwa mit zumindest einem Magneten ausgestatteten Betätigungselementes ermöglicht und andererseits die elektrische Schnittstelle zwischen Aktor und Schaltgerät. So ist ein besonders einfacher Umbau möglich. So kann auch vorgesehen sein, dass im Rahmen des Nachrüstens der Magnet an dem Betätigungselement angeschlossen wird.

Als Nachrüstsatz weist das Funktionsmodul üblicherweise ein Gehäuse auf, in dessen Innenraum auf zumindest einer elektrischen Leiterplatte zur Funktion notwendige elektrische/elektronische Bauteile untergebracht sind. Dabei weist die zumindest eine elektrische Leiterplatte zum Anschluss mehrerer elektrischer Leitungen zumindest eine Schnittstelle auf. So sind üblicherweise alle für den Betrieb erforderlichen Komponenten kompakt in einem typischerweise abgeschlossenen Gehäuse angeordnet, nach außen aufweisend die zum Betrieb erforderlichen Schnittstellen, insbesondere zum Ansteuern des Aktors und ggf. zur eigenen Stromversorgung. Die Stromversorgung kann auch durch eine Batterie oder durch die dem Aktor zur Verfügung gestellte, respektive geschaltete Energie oder einer Kombination daraus bereitgestellt werden. Durch die dadurch gewonnene Autarkie ist eine einfache Montage gewährleistet. Hierzu wird üblicherweise das Schaltgerät ausgebaut, das Funktionsmodul in den freigelegten Installationshohlraum eingelegt, die Kabel von dem Schaltmodul abgeklemmt und stattdessen an das Funktionsmodul angeschlossen, anschließend das Schaltmodul wieder in den Installationshohlraum eingesetzt und abschließend das Oberteil auf das Schaltgerät aufgesteckt.

Zum funktionsmodulseitigen Erkennen, um welche Art von Schaltgerät es sich bei dem installierten Schaltgerät handelt, wird bevorzugt eine vorgegebene Betätigung des Schaltgerätes während einer Einrichteroutine durch einen Nutzer durchgeführt. Anhand der zeitaufgelösten Erkennung des Magnetfeldes können Muster erkannt werden, die auf eine bestimmte Schaltgeräteart rückschließen lassen. So verbleibt bei einer einmaligen Betätigung ein Schalter in seiner Stellung, während ein Taster in seine Ursprungsstellung selbstständig zurückkehrt. Wieder anders verhält sich ein Drehknopf. Die dazugehörigen Muster der Veränderung des Magnetfeldes werden mit in dem Funktionsmodul hinterlegten oder über eine externe Datenverbindung zur Verfügung gestellten Mustern verglichen, sodass auf die Schaltgeräteart auf diese Weise vollautomatisch geschlossen werden kann. Auch ist auf diese Weise eine Kalibrierung des Magnetfeldsensor möglich, insbesondere in Bezug auf ein Oberteil, welches mehrkanalig genutzt wird (etwa ein Doppelschalter oder -taster).

Der Magnetfeldsensor des Funktionsmoduls erfasst das Magnetfeld bevorzugt dreidimensional, da hierdurch eine besonders einfache und zuverlässige Eindeutigkeit der Stellung des oder der Betätigungselemente, insbesondere auch bei einer Mehrkanaligkeit, erreicht werden kann. Auch werden hierdurch die unterschiedlichen Bewegungen unterschiedlicher Schaltgerätearten erkannt.

Durch die dreidimensionale Erfassung kann auch vorgesehen sein, lediglich einen Magnetfeldsensor zum Betrieb des Funktionsmoduls zu nutzen. So kann auch ein mehrkanaliges Schaltgerät, umfassend eine Mehrzahl an Betätigungselementen, mit nur einem einzelnen Funktionsmodul betrieben werden.

Bevorzugt ist vorgesehen, dass für jede Aktorart (etwa Leuchten, Steckdosen oder Jalousien) je ein Funktionsmodul vorgesehen ist. Somit ist für ein bestimmtes Funktionsmodul der zu schaltende Aktor bekannt, sodass dass das Funktionsmodul bezüglich einer Ansteuerung hierauf abgestimmt sein kann. Hierdurch wird der benötigte Speicherplatz innerhalb des Funktionsmoduls reduziert.

Ferner kann vorgesehen sein, dass in dem Funktionsmodul für eine bestimmte Aktorart eine bestimmte aktorartspezifische Funktion implementiert ist, die auf Basis einer Standardbetätigung ausgelegt ist. Beim Auslösen der Funktion wird dann durch das Funktionsmodul die tatsächliche schaltgeräteseitige Betätigungsart in die funktionsseitige Standardbetätigung softwareseitig umgewandelt, wenn diese von der Standardbetätigung abweicht. Als Beispiel: Angenommen, die Funktion ist für einen Taster konzipiert, die Standardbetätigung ist somit diejenige eines Tasters. Wird durch das Funktionsmodul erkannt, dass es sich bei dem Schaltgerät tatsächlich um einen Schalter handelt (die tatsächliche Betätigung ist diejenige eines Schalters), wandelt es die Schaltbetätigung intern als Tastersignal um und sendet diese an die aktorartspezifische Funktion zum Ansteuern des Aktors. Auf diese Weise muss nur für eine einzige Betätigungsart die entsprechende Funktion in dem, üblicherweise kompakt ausgeführten Funktionsmodul gespeichert werden, während trotzdem eine Ansteuerung mittels verschiedener Schaltgerätearten möglich ist. Hierdurch wird Speicherplatz gespart. Auch das Updaten der Funktion wird vereinfacht, da weniger Daten übertragen werden müssen.

Besonders bevorzugt weist das erfindungsgemäße Funktionsmodul einen Dimmaktor zum Dimmen von dimmbaren Lasten, etwa Leuchtmitteln auf. Auf diese Art und Weise kann nicht nur die Funktionalität des Dimmens dimmbarer Lasten realisiert werden, sondern wird dadurch auch ermöglicht, das Dimmen ohne einen Taster (oder mittels eines Drehknopfs) zu verwenden. Damit wird der infrastrukturelle Aufwand erheblich abgesenkt, so dass der Anwender eher dazu angeregt wird, ein erfindungsgemäßes Funktionsmodul zu installieren.

Gemäß einer besonders bevorzugten Weiterbildung dieses einen Dimmaktor aufweisenden erfindungsgemäßen Funktionsmoduls weist die Schnittstelle maximal einen Anschluss für den Neutralleiter, einen Anschluss für die Phase und einen Anschluss für die zu dimmende Last auf. Eine Verdrahtung des Funktionsmoduls mit dem elektromechanischen Schaltgerät entfällt. Mithin werden lediglich drei statt fünf Kabel (bei einem Zwei-Wege-Dimmer mit einer Taste sogar sechs Kabel) beziehungsweise im Zweidrahtbetrieb zwei statt vier Kabel (bei einem Zwei-Wege-Dimmer mit einer Taste sogar fünf Kabel) benötigt. Hierdurch kann vorteilhafterweise nicht nur der Installationsaufwand abgesenkt, sondern auch ein erheblicher Bauraum in der Installationsdose eingespart werden.

In einer alternativen Weiterbildung des erfindungsgemäßen Funktionsmoduls weist das Funktionsmodul einen Schaltaktor, insbesondere zum Schalten von Steckdosen, auf. Die Steckdose ist üblicherweise eine haushaltsübliche Steckdose zur Versorgung von elektrischen/elektronischen Geräten mit einer Spannung von etwa 110-230V, kann aber auch proprietäre Systeme mit einer Niederspannung umfassen. Da die Stellung des Schaltgerätes magnetisch über den Magnetsensor erfasst wird, entfällt eine aufwendige Verdrahtung des Funktionsmoduls mit dem elektromechanischen Schaltgerät.

Gemäß einer besonders bevorzugten Weiterbildung dieses einen Schaltaktor aufweisenden erfindungsgemäßen Funktionsmoduls weist die Schnittstelle maximal einen Anschluss für den Neutralleiter, einen Anschluss für die Phase und einen Anschluss für die zu schaltende Last auf. Mithin werden lediglich drei statt fünf Kabel benötigt. Hierdurch kann vorteilhafterweise nicht nur der Installationsaufwand abgesenkt, sondern auch ein erheblicher Bauraum in der Installationsdose eingespart werden.

In einer alternativen Weiterbildung des erfindungsgemäßen Funktionsmoduls weist das Funktionsmodul einen Jalousieaktor zum Steuern von Jalousien auf. Da die Stellung des Schaltgerätes magnetisch über den Magnetsensor erfasst wird, entfällt eine Verdrahtung des Funktionsmoduls mit dem elektromechanischen Schaltgerät.

Gemäß einer besonders bevorzugten Weiterbildung dieses einen Jalousieaktor aufweisenden erfindungsgemäßen Funktionsmoduls weist die Schnittstelle maximal einen Anschluss für den Neutralleiter, einen Anschluss für die Phase und zwei Anschlüsse für die zu steuernde Last auf. Mithin werden lediglich vier statt sieben Kabel benötigt. Hierdurch kann vorteilhafterweise nicht nur der Installationsaufwand abgesenkt, sondern auch ein erheblicher Bauraum in der Installationsdose eingespart werden.

In einer alternativen Weiterbildung des erfindungsgemäßen Funktionsmoduls weist das Funktionsmodul einen Tastsensor zum Betätigen eines elektrischen Gerätes auf. Da die Stellung des Schaltgeräts magnetisch über den Magnetsensor erfasst wird, entfällt vorteilhafterweise eine Verdrahtung des Funktionsmoduls mit dem elektromechanischen Schaltgerät.

Gemäß einer besonders bevorzugten Weiterbildung dieses einen Tastsensor aufweisenden erfindungsgemäßen Funktionsmoduls weist die Schnittstelle maximal einen Anschluss für den Neutralleiter und einen Anschluss für die Phase auf. Mithin werden lediglich zwei statt fünf Kabel benötigt (Anmerkung: Es ist entweder ein Anschluss über den Neutralleiter oder über eine Steuerleitung erforderlich). Hierdurch kann vorteilhafterweise nicht nur der Installationsaufwand abgesenkt, sondern auch ein erheblicher Bauraum in der Installationsdose eingespart werden.

In einer besonders bevorzugten Weiterbildung des erfindungsgemäßen Funktionsmoduls weist das Funktionsmodul einen Energiespeicher, insbesondere eine Batterie oder ein Akku, zur Energieversorgung auf. Hierdurch wird vorteilhafterweise erreicht, dass der Verdrahtungsaufwand noch weiter reduziert wird, da ein Anschluss an den Neutralleiter und ein Anschluss an die Phase ebenfalls entfallen kann.

In einer bevorzugten Weiterbildung des erfindungsgemäßen Funktionsmoduls ist der Magnetfeldsensor ein MEMS-Magnetsensor, auch bekannt als Mikrosystemtechnik (MST)-Sensor. Aufgrund der geringen Größe des MEMS-Magnetsensor kann dieser besonders nahe am Messort platziert werden, wodurch eine höhere räumliche Auflösung im Vergleich zu anderen Magnetfeldsensoren erreicht wird. Zudem ist der MEMS-Magnetsensor besonders kostengünstig und erlaubt eine besonders präzise mehrdimensionale vektorielle Auswertung.

In einer Weiterbildung des erfindungsgemäßen Funktionsmoduls ist der Magnet an der von der durch einen Nutzer sichtbaren abgewandten Seite des Oberteils, respektive des Betätigungselementes angeordnet, also: an der Innenseite des Oberteils. Damit ist der Magnet, der etwa von dem Betätigungselement hervorstehen kann, nicht für den Anwender sichtbar angeordnet.

In einer weiteren Weiterbildung des erfindungsgemäßen Funktionsmoduls ist der Magnet an das Oberteil geklebt oder mechanisch an ihm fixiert. Diese Art der Befestigung ist besonders einfach und kostengünstig zu realisieren.

Üblicherweise ist das Funktionsmodul rückwärtig zu dem Schaltgerät innerhalb des für das Schaltgerät vorgesehenen Installationshohlraumes, etwa einer Hohlwanddose, angeordnet. Für eine eindeutige Ausrichtung bei der Montage ist das Funktionsmodul an einen üblichen Installationshohlraum in seinen Außendimensionen angepasst, üblicherweise zumindest über ein Segment, etwa mehr als 180° kreisrund.

Ferner betrifft die Erfindung ein Verfahren zum Betrieb eines Funktionsmoduls für ein Schaltgerät der Gebäudeinstallationstechnik, umfassend die Schritte:
- Erfassen des Magnetfeldes durch den Magnetfeldsensor, welches durch das an dem elektrischen/elektronischen Schaltgerätes angeordneten Magneten an dem Magnetfeldsensor des Funktionsmoduls erzeugt wird,
- Erfassen der Änderung des Magnetfeldes in Folge einer vorbestimmten Betätigung des Betätigungselementes,
- Auswerten der erfassten Änderung des Magnetfeldes durch eine Auswerteeinheit, dahingehend, um welche Schaltgeräteart es sich bei dem Schaltgerät handelt, insbesondere ob es sich um einen Schalter oder Taster handelt, und
- Ansteuerung eines Aktors durch das Funktionsmodul entsprechend einer vorgegebenen Funktionsweise in Abhängigkeit der Schaltgeräteart.

Nachfolgend ist die Erfindung unter Bezugnahme auf die beigefügten Figuren anhand diverser Ausführungsbeispiele beschrieben. Es zeigen:
- **Fig. 1:**: Eine schematische Darstellung des erfindungsgemäßen, einen Schaltaktor aufweisenden Funktionsmoduls (rechts) im Vergleich zu einem vorbekannten Funktionsmodul (links), jeweils inklusive angedeuteter Verdrahtung bezüglich des Schaltgeräts,
- **Fig. 2:**: eine schematische Darstellung des erfindungsgemäßen, einen Jalousieaktor aufweisenden Funktionsmoduls (rechts) im Vergleich zu einem vorbekannten Funktionsmodul (links), jeweils inklusive angedeuteter Verdrahtung bezüglich des Schaltgeräts,
- **Fig. 3:**: eine schematische Darstellung des erfindungsgemäßen, eine Tasterschnittstelle aufweisenden Funktionsmoduls (rechts) im Vergleich zu einem vorbekannten Funktionsmodul (links), jeweils inklusive angedeuteter Verdrahtung bezüglich des Schaltgeräts, und
- **Fig. 4:**: eine schematische Darstellung des erfindungsgemäßen, einen Dimmaktor aufweisenden Funktionsmoduls (rechts) im Vergleich zu einem vorbekannten Funktionsmodul (links), jeweils inklusive angedeuteter Verdrahtung bezüglich des Schaltgeräts.

In den verschiedenen Figuren sind gleiche Teile stets mit den gleichen Bezugszeichen versehen und werden daher in der Regel auch jeweils nur einmal benannt beziehungsweise erwähnt.

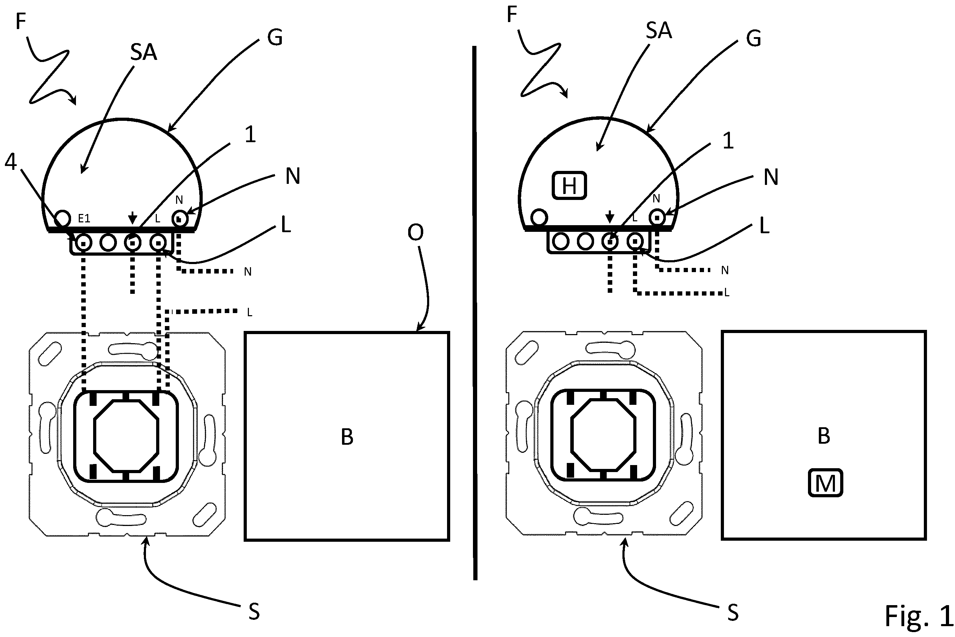

Figur 1 zeigt links ein herkömmliches Funktionsmodul F zum Einbau in eine Installationsdose für ein elektrisches/elektronisches Schaltgerät S der Gebäudeinstallationstechnik, wobei das Funktionsmodul F mittels eines Betätigungselementes B eines Oberteils O des elektrischen/elektronischen Schaltgerätes S durch mechanische Betätigung, insbesondere durch Betätigung einer Schaltwippe, beeinflussbar ist. Dieses Funktionsmodul F umfasst ein Gehäuse G, in dessen Innenraum auf zumindest einer elektrischen Leiterplatte zur Funktion notwendige elektrische/elektronische Bauteile untergebracht sind. Dabei weist die zumindest eine elektrische Leiterplatte zum Anschluss mehrerer elektrischer Leitungen zumindest eine Schnittstelle auf. Das vorliegende einen Schaltaktor SA umfassende Funktionsmodul F kann in dieser Ausführungsform über diese Schnittstelle eine Steckdose schalten. Dafür ist bei der erfindungsgemäßen Anordnung, umfassend das Funktionsmodul F (rechts abgebildet) an dem Oberteil O des elektrischen/elektronischen Schaltgerätes S mindestens ein Magnet M angeordnet, welcher bei Betätigung des Betätigungselementes B seine Position ändert. Diese Änderung der Position, insbesondere durch ein Schwenken entlang der Drehachse einer Schaltwippe, wird in dem Funktionsmodul F über einen Sensor H zur Erfassung des Magnetfeldes erfasst. Die sensierte Änderung des Magnetfeldes wird anschließend in einer Auswerteeinheit zur Identifikation des elektrischen/elektronischen Schaltgerätes S als Schalter ausgewertet. Bei einem Schalter kann es sich auch um einen Drehschalter handeln. Damit kann sichergestellt werden, dass die Ansteuerung eines elektrischen Gerätes, beispielsweise einer Steckdose, durch das Funktionsmodul F so erfolgt, dass das elektrische/elektronische Schaltgerät S als Schalter erkannt und angesteuert wird. Eine Ansteuerung als Schalter unterscheidet sich fundamental von der eines Tasters, insbesondere dahingehend, dass der Schalter nicht in seine Ursprungsposition zurückspringt und somit der Schalter eine permanente Offen- beziehungsweise Geschlossenen-Stellung einnimmt. Dieses erlaubt eine Auswertung beziehungsweise Identifikation durch die Auswerteeinheit als Schalter beziehungsweise als Taster. Eine solche Identifikation durch die Auswerteeinheit kann beispielsweise erfolgen, indem das Magnetfeld zeitaufgelöst erfasst wird, wobei sich auf vorteilhafte Weise zu Nutze gemacht wird, dass bei einer Schalterbetätigung, um dieselbe Magnetfeldänderung wie bei einer Tastbetätigung herbeizuführen, der Bediener bei der Bedienung umgreifen muss (Doppelbetätigung), so dass die Schalterbetätigung regelmäßig länger dauert als eine Tastbetätigung (Einfachbetätigung reicht aus). Dieses erlaubt eine einfache und zuverlässige Identifikation des elektrischen/elektronischen Schaltgerätes S als Taster oder Schalter. Eine solche Identifikation kann alternativ auch erreicht werden, indem eine manuelle Vor-Orteinstellung am Funktionsmodul (beispielsweise über eine Einstellmöglichkeit am Funktionsmodul) oder über eine Fernbetätigung (beispielsweise über eine Applikation auf einem mobilen Endgerät oder über anderweitig über eine Funkkommunikation) vorgenommen wird.

Die mathematische Auswertung des durch den Magnetfeldsensor erfassten Magnetfeldes erfolgt vektoriell, da hierdurch eine besonders einfache und zuverlässige Eindeutigkeit der Stellung des Oberteils O, insbesondere auch bei einer Mehrkanaligkeit, erreicht werden kann. Damit wird durch das erfindungsgemäße Funktionsmodul F erreicht, dass das elektrische/elektronische Schaltgerät S zwar noch als mechanischer Schalter zur Aufnahme einer Wippe dient, dieses elektrische/elektronische Schaltgerät S jedoch keine elektronische Verbindung, also: Verdrahtung, zu dem Funktionsmodul F mehr aufweist. Hierdurch wird der insgesamt zu leistende Verdrahtungsaufwand erheblich reduziert. Ebenfalls wird hierdurch verhindert, dass sich beim Einsetzen des Funktionsmoduls F in die Installationsdose möglicherweise angeschlossenes Kabelgut löst.

Besonders vorteilhaft - insbesondere mit Blick auf den Installationsaufwand (weniger Verdrahtungsaufwand) und die Installationsinfrastrukturanforderungen (Schalter statt Taster) - bei der in Figur 1 gezeigten Schnittstelle ist, wenn sie maximal einen Anschluss für den Neutralleiter N, einen Anschluss für die Phase L und einen Anschluss für die zu schaltende Last (der Übersichtlichkeit halber nicht dargestellt) über eine Steuerleitung 1 aufweist.

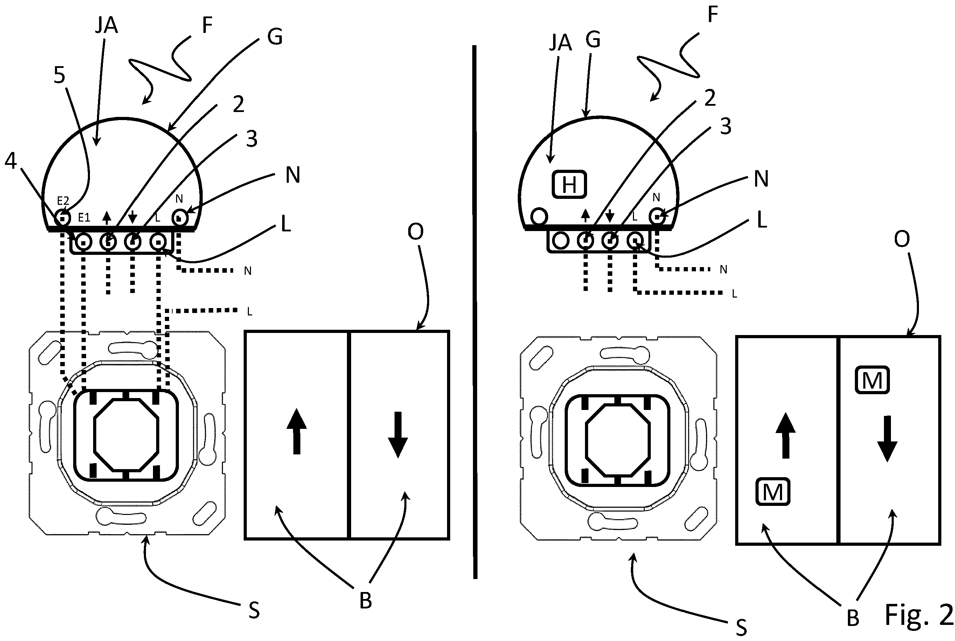

Noch beachtlicher wird der Einspareffekt hinsichtlich des Verdrahtungsaufwandes anhand eines in Figur 2 (rechts abgebildeten) erfindungsgemäßen Funktionsmoduls F, welches einen Jalousieaktor JA aufweist. Bei einem solchen Jalousieaktor JA, welcher herkömmlicherweise zwei Steuerleitungen 2, 3 neben dem Anschluss an den Neutrallleiter N und die Phase L, sowie zwei weiteren Steuerleitungen 4, 5 aufweist, kann die Anzahl der zu verwendenden Drähte von sieben auf vier reduziert werden. Da der Bauraum in den Installationsdosen regelmäßig sehr knapp ist, stellt jeder einzelne Draht, der nicht an das Funktionsmodul F beziehungsweise das Schaltgerät angeschlossen werden muss, einen nicht zu unterschätzenden Vorteil dar.

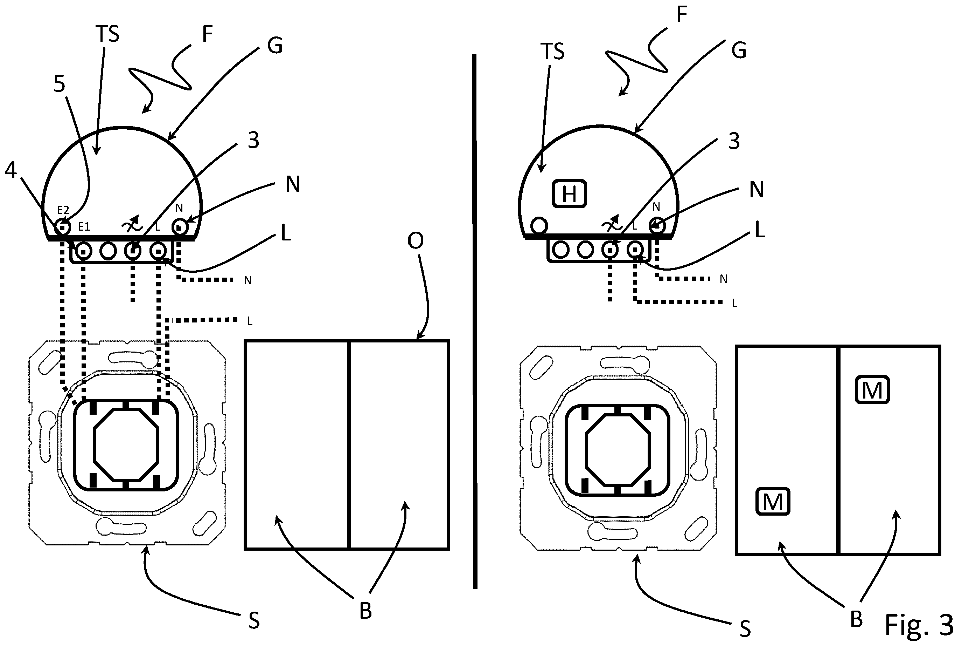

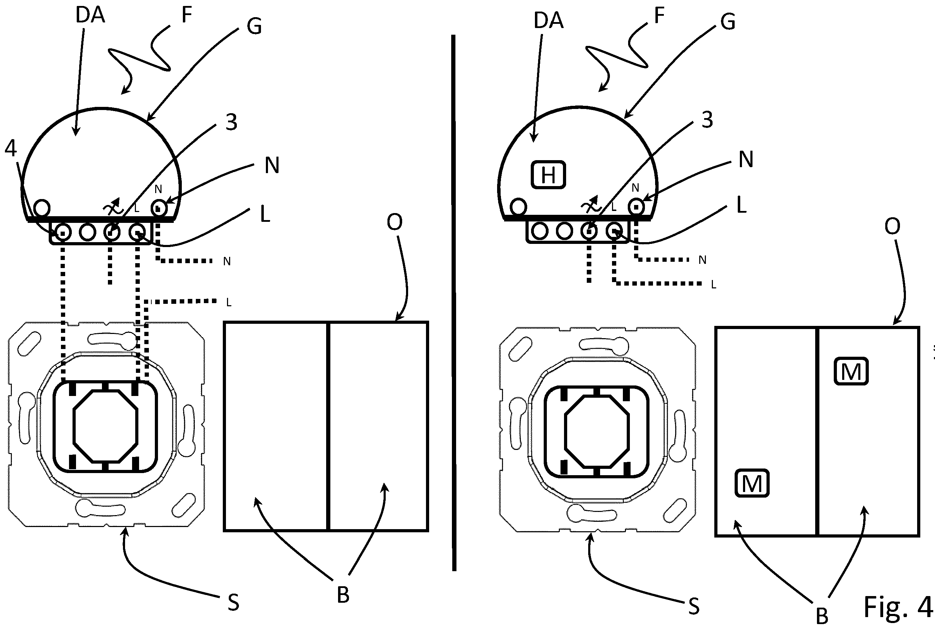

In analogerweise sind in den Figuren 3 und 4 eine Tasterschnittstelle TS beziehungsweise einen Dimmaktor DA aufweisende erfindungsgemäße Funktionsmodule F insbesondere hinsichtlich ihrer Verdrahtung abgebildet. In Figur 3 ist dabei (neben dem selbstverständlichen Anschluss des Phase L) entweder der Neutralleiter N oder die Steuerleitung 3 an das Funktionsmodul F angeschlossen. Gleiches ist bei Figur 4 auch der Fall (Zweidrahtbetrieb) oder es ist die der Neutralleiter N und die Steuerleitung 3 angeschlossen (Dreidrahtbetrieb). Auch hier ist erkennbar, dass der Verdrahtungsaufwand erheblich verringert ist. Zudem wird analog zu den vorbeschriebenen Ausführungsformen erreicht, dass eine Verwendung eines Tasters anstelle eines Schalters wirksam vermieden ist, da die beschriebene magnetische Detektion und Auswertung der Schaltbetätigung anstelle einer elektromechanische Schalterbetätigung gesetzt wird.

In allen Ausführungsformen kann der Verdrahtungsaufwand mit Blick auf den Anschluss des erfindungsgemäßen Funktionsmoduls F an die Phase L und den Neutralleiter N noch weiter abgesenkt werden, wenn das Funktionsmodul F über einen Energiespeicher, insbesondere eine Batterie, energieversorgt ist.

Die Erfindung ist anhand von Ausführungsbeispielen beschrieben. Ohne den Umfang der geltenden Ansprüche zu verlassen, ergeben sich für einen Fachmann zahlreiche weitere Möglichkeiten, diese umzusetzen, ohne dass dieses im Rahmen dieser Ausführungen im Einzelnen erläutert werden müsste.

### Bezugszeichenliste

- B: Betätigungselement
- DA: Dimmaktor
- F: Funktionsmodul
- G: Gehäuse
- JA: Jalousieaktor
- L: Phase
- H: Sensor
- M: Magnet
- N: Neutralleiter
- O: Oberteil
- SA: Schaltaktor
- S: elektrisches/elektronisches Schaltgerät
- TA: Tasterschnittstelle
- 1-5: Steuerleitungen

## Patentansprüche

1. Anordnung eines Funktionsmoduls (F) zum Einbau in eine Installationsdose mit einem manuell zu betätigenden Schaltgerät (S) der Gebäudeinstallationstechnik, welches Funktionsmodul (F) durch die Betätigung eines an dem Schaltgerät (S) angeschlossenen Betätigungselementes (B) eines Oberteils (O) des Schaltgerätes (S) beeinflussbar ist, wobei das Funktionsmodul (F) zumindest eine Schnittstelle aufweist, mittels welcher zumindest ein Aktor entsprechend einer Betätigung des Betätigungselements (B) ansteuerbar ist, wobei an dem Schaltgerät (S) mindestens ein Magnet (M) angeordnet ist, welcher bei Betätigung des Betätigungselementes (B) seine Position ändert, und dass das Funktionsmodul (F) einen Sensor (H) zur Erfassung des Magnetfeldes aufweist, so dass die Änderung des Magnetfeldes bei Betätigung des Betätigungselementes (B) detektiert wird, **dadurch gekennzeichnet, dass** das Funktionsmodul (F) eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät (S) handelt, welche Identifikation in die funktionsmodulseitige Ansteuerung des Aktors einfließt.

2. Anordnung nach Anspruch 1, **dadurch gekennzeichnet, dass** der zumindest eine Magnet (M) an dem Betätigungselement (B) angeordnet ist.

3. Anordnung nach Anspruch 2, **dadurch gekennzeichnet, dass** der Magnet (M) an der von dem Benutzer im Betrieb abgewandten Seite des Betätigungselementes angeordnet ist.

4. Anordnung nach einem der Ansprüche 1 bis 3, **dadurch gekennzeichnet, dass** das Schaltgerät (S) als Taster oder als Schalter ausgebildet ist.

5. Anordnung nach einem der Ansprüche 1 bis 4, **dadurch gekennzeichnet, dass** das Funktionsmodul über alle für seine Funktion notwendigen Bauteile in einem abgeschlossenen Gehäuse verfügt und die Schnittstelle lediglich die notwendigen Anschlüsse zu einer eigenen Stromversorgung und optional zum Ansteuern zumindest eines zu schaltenden Aktors aufweist.

6. Anordnung nach einem der Ansprüche 1 bis 5, **dadurch gekennzeichnet, dass** das Funktionsmodul (F) einen Dimmaktor zum Dimmen einer dimmbaren Last umfasst.

7. Anordnung nach einem der Ansprüche 1 bis 5, **dadurch gekennzeichnet, dass** das Funktionsmodul (F) einen Schaltaktor, insbesondere zum Schalten von Steckdosen, üblicherweise haushaltsüblicher Steckdosen, umfasst.

8. Anordnung nach einem der Ansprüche 1 bis 5, **dadurch gekennzeichnet, dass** das Funktionsmodul (F) einen Jalousieaktor (JA) zum Steuern von Jalousien umfasst.

9. Anordnung nach einem der Ansprüche 1 bis 5, **dadurch gekennzeichnet, dass** das Funktionsmodul (F) einen Tastsensor zum Betätigen eines elektrischen Gerätes umfasst.

10. Anordnung nach einem der Ansprüche 1 bis 9, **dadurch gekennzeichnet, dass** der Magnetfeldsensor ein MEMS-Magnetsensor ist.

11. Anordnung nach einem der Ansprüche 1 bis 10, **dadurch gekennzeichnet, dass** der Magnet (M) an das Betätigungselement geklebt oder mechanisch an ihm fixiert ist.

12. Anordnung nach einem der Ansprüche 1 bis 11, **dadurch gekennzeichnet, dass** das Funktionsmodul (F) über einen Energiespeicher, insbesondere eine Batterie, energieversorgt ist.

13. Verfahren zum Betrieb eines Funktionsmoduls (F) einer Anordnung nach einem der Ansprüche 1 bis 12, umfassend die Schritte:
- Erfassen des Magnetfeldes durch den Magnetfeldsensor (H), welches durch das an dem elektrischen/elektronischen Schaltgerätes (S) angeordneten Magneten (M) an dem Magnetfeldsensor (H) des Funktionsmoduls erzeugt wird,
- Erfassen der Änderung des Magnetfeldes in Folge einer vorbestimmten Betätigung des Betätigungselementes (B),
- Auswerten der erfassten Änderung des Magnetfeldes durch eine Auswerteeinheit, dahingehend, um welche Schaltgeräteart es sich bei dem Schaltgerät handelt, insbesondere ob es sich um einen Schalter oder Taster handelt, und
- Ansteuerung eines Aktors durch das Funktionsmodul (F) entsprechend einer vorgegebenen Funktionsweise in Abhängigkeit der Schaltgeräteart.

## Claims

1. Arrangement of a function module (F) for installing in an installation box with a manually operable switching device (S) used in building installation technology, which function module (F) can be influenced by actuation of an actuating element (B) connected to the switching device (S) and associated with an upper part (O) of the switching device (S), wherein the function module (F) has at least one interface, by means of which at least one actuator can be activated in accordance with an actuation of the actuation element (B), wherein at least one magnet (M), which changes its position when the actuating element (B) is actuated, is arranged on the switching device (S), and wherein the function module (F) has a sensor (H) for sensing the magnetic field, so that the change in the magnetic field is detected when the actuating element (B) is actuated, **characterised in that** the function module (F) has an evaluation unit for evaluating the magnetic field, which is configured such as to identify, as a dependency of the change in the magnetic field which has been sensed, which switching device (S) is concerned, and this identification is then integrated into actuation and control of the actuator on the function module side.

2. Arrangement according to claim 1, **characterised in that** the at least one magnet (M) is arranged at the actuating element (B).

3. Arrangement according to claim 2, **characterised in that** the magnet (M) is arranged on the side of the actuating element which faces away from the user when in operation.

4. Arrangement according to any one of claims 1 to 3, **characterised in that** the switching device (S) is configured as a button or switch.

5. Arrangement according to any one of claims 1 to 4, **characterised in that** the function module contains all the components necessary for its function in a closed housing, and the interface comprises only the connections necessary for its own power supply, and optionally for the actuation and control of an actuator which is to be connected.

6. Arrangement according to any one of claims 1 to 5, **characterised in that** the function module (F) comprises a dimming actuator for dimming a dimmable load.

7. Arrangement according to any one of claims 1 to 5, **characterised in that** the function module (F) comprises a switching actuator, in particular for switching plug sockets, usually conventional household plug sockets.

8. Arrangement according to any one of claims 1 to 5, **characterised in that** the function module (F) comprises a roller blind actuator (JA) for controlling roller blinds.

9. Arrangement according to any one of claims 1 to 5, **characterised in that** the function module (F) comprises a tactile sensor for actuating an electrical device.

10. Arrangement according to any one of claims 1 to 9, **characterised in that** the magnetic field sensor is a MEMS magnetic sensor.

11. Arrangement according to any one of claims 1 to 10, **characterised in that** the magnet (M) is adhesively bonded to the actuating element or fixed to it by mechanical means.

12. Arrangement according to any one of claims 1 to 11, **characterised in that** the function module (F) is supplied with energy by an energy storage device, in particular a battery.

13. Method for operating a function module (F) of an arrangement according to any one of claims 1 to 12, comprising the steps:
- Sensing by the magnetic field sensor (H) of the magnetic field, which is produced by the magnet (M) arranged at the electrical/electronic switching device (S), at the magnetic field sensor (H) of the function module,
- sensing of the change in the magnetic field as a consequence of a predetermined actuation of the actuating element (B),
- evaluating the detected change in the magnetic field by an evaluation unit, depending on which type of switching device is concerned, in particular whether it is a switch or a button, and
- actuating an actuator by the function module (F) in accordance with a predetermined function mode, depending on the type of switching device.

## Revendications

1. Agencement d'un module fonctionnel (F) à intégrer dans une boîte d'installation comportant un dispositif de commutation (S) à actionner manuellement destiné à la technique d'installation des bâtiments, lequel module fonctionnel (F) peut être influencé par l'actionnement d'un élément d'actionnement (B) raccordé sur le dispositif de commutation (S), sur la partie supérieure (O) du dispositif de commutation (S), le module fonctionnel (F) présentant au moins une interface, grâce à laquelle au moins un actionneur peut être commandé en fonction de l'actionnement de l'élément d'actionnement (B), au moins un aimant (M) dont la position change lors de l'actionnement de l'élément d'actionnement (B) étant disposé sur le dispositif de commutation (S) ; et le module fonctionnel (F) présentant un détecteur (H) destiné à identifier le champ magnétique de manière à détecter le changement de champ magnétique lors de l'actionnement de l'élément d'actionnement (B), **caractérisé en ce que** le module fonctionnel (F) présente une unité de traitement destinée à analyser le changement de champ magnétique, laquelle est paramétrée pour identifier, en fonction du changement de champ magnétique détecté, quel est le type du dispositif de commutation (S), laquelle identification est prise en compte par la commande de l'actionneur au niveau du module fonctionnel.

2. Agencement selon la revendication 1, **caractérisé en ce que** l'au moins un aimant (M) est disposé sur l'élément d'actionnement (B).

3. Agencement selon la revendication 2, **caractérisé en ce que** l'aimant (M) est disposé sur le côté de l'élément d'actionnement à l'opposé de l'utilisateur lors du fonctionnement.

4. Agencement selon l'une des revendications 1 à 3, **caractérisé en ce que** le dispositif de commutation (S) est conformé en bouton-poussoir ou commutateur.

5. Agencement selon l'une des revendications 1 à 4, **caractérisé en ce que** le module fonctionnel dispose de toutes les pièces nécessaires à son fonctionnement dans un boîtier fermé et que l'interface présente uniquement les raccordements nécessaires pour sa propre alimentation électrique et, en option, pour commander au moins un des actionneurs à commuter.

6. Agencement selon l'une des revendications 1 à 5, **caractérisé en ce que** le module fonctionnel (F) comporte un actionneur variateur pour graduer une charge variable.

7. Agencement selon l'une des revendications 1 à 5, **caractérisé en ce que** le module fonctionnel (F) comporte un actionneur commutateur, notamment pour commuter des prises de courant, usuellement des prises de courant domestiques.

8. Agencement selon l'une des revendications 1 à 5, **caractérisé en ce que** le module fonctionnel (F) comporte un actionneur de stores (JA) pour commander des stores.

9. Agencement selon l'une des revendications 1 à 5, **caractérisé en ce que** le module fonctionnel (F) comporte un détecteur tactile pour actionner un appareil électrique.

10. Agencement selon l'une des revendications 1 à 9, **caractérisé en ce que** le détecteur de champs magnétiques est un détecteur MEMS.

11. Agencement selon l'une des revendications 1 à 10, **caractérisé en ce que** l'aimant (M) est collé sur l'élément d'actionnement ou fixé mécaniquement sur ce dernier.

12. Agencement selon l'une des revendications 1 à 11, **caractérisé en ce que** le module fonctionnel (F) est alimenté en énergie par une réserve énergétique, notamment une batterie.

13. Procédé pour faire fonctionner un module fonctionnel (F) dans un agencement selon l'une des revendications 1 à 12, comportant les étapes suivantes:
- Détection d'un champ magnétique par un détecteur de champs magnétiques (H), lequel est généré par l'aimant (M) disposé sur le dispositif de commutation (S) électrique/électronique, au niveau du détecteur de champs magnétiques (H) du module fonctionnel.
- Détection d'un changement du champ magnétique à la suite d'un actionnement préalablement défini de l'élément d'actionnement (B),
- Analyse du changement de champ magnétique détecté par une unité de traitement, visant à définir quel est le type du dispositif de commutation, notamment s'il s'agit d'un commutateur ou d'un bouton-poussoir, et
- Commande d'un actionneur par le module fonctionnel (F) selon un mode de fonctionnement préalablement défini, en fonction du type de dispositif de commutation.
